# EUROPEAN PATENT SPECIFICATION

(11) **EP 0 426 252 B1**
(45) Date of publication and mention of the grant of the patent: **24.08.1994**
(21) Application number: 90202862.0
(22) Date of filing: 29.10.1990
(51) Int. Cl.: H01L 29/06, H01L 21/18

(54) **A semiconductor device and method of manufacturing a semiconductor device**
Halbleiteranordnung und Verfahren zu ihrer Herstellung
Dispositif semi-conducteur et sa méthode de fabrication

(30) Priority: 01.11.1989 GB 8924557
(43) Date of publication of application: 08.05.1991
(73) Proprietor: PHILIPS ELECTRONICS UK LIMITED, Croydon CR9 3QR (GB); Philips Electronics N.V., 5621 BA Eindhoven (NL)
(72) Inventor: Slatter, John Alfred George, Surrey, RH1 5HA (GB); Brockman, Henry Edward, Surrey, RH1 5HA (GB); Yule, David Caldecott, Surrey, RH1 5HA (GB)
(74) Representative: Stevens, Brian Thomas

(56) References cited:
- EP-A- 0 146 181
- EP-A- 0 255 971
- FR-A- 2 181 075
- US-A- 4 267 557

## Description

This invention relates to a semiconductor device and to a method of manufacturing a semiconductor device.

US-A-4003072 describes a semiconductor device comprising a semiconductor body having a first device region of one conductivity type forming with a second device region of the opposite conductivity type provided adjacent one of the major surfaces of the semiconductor body a first pn junction which is reverse-biassed in at least one mode of operation of the device, and a floating further region of the opposite conductivity type provided within the first device region remote from the major surfaces of the semiconductor body and spaced from the second device region so that, in the one mode of operation of the device, the depletion region of the first pn junction reaches the floating further region before the first pn junction breaks down.

Such a device is shown in, for example, Figure 5 of US-A-4003072 where an array of floating further regions is provided. The floating further regions act to increase the voltage at which the device breaks down when the first pn junction is reverse-biassed in operation of the device. Thus, when under such reverse-biassing conditions the first region is depleted of free charge carriers, the ionised impurity atoms in the further floating regions act to divert electric field lines from the oppositely charged ionised impurity atoms in the first device region. These electric field lines would otherwise serve to increase the field at the first pn junction and help to cause breakdown at the first pn junction. However, because of the tendency of the pn junction(s) between the floating further region(s) and the first device region to become forward-biassed, which reduces the potential between the second device region and the floating region and may cause the potential of the floating region to become fixed, it is difficult for high electric fields to exist above the floating further region(s). This adversely affects the reverse breakdown voltages which can be attained.

It is an aim of the present invention to provide a semiconductor device and a method of manufacturing such a semiconductor device which overcomes or at least mitigates the above-mentioned problems enabling even higher breakdown voltages to be achieved.

According to one aspect of the present invention, there is provided a semiconductor device comprising a semiconductor body having a first device region of one conductivity type forming with a second device region of the opposite conductivity type provided adjacent one of the major surfaces of the semiconductor body a first pn junction which is reverse-biassed in at least one mode of operation of the device, and a floating further region of the opposite conductivity type provided within the first device region remote from the major surfaces of the semiconductor body and spaced from the second device region so that, in the one mode of operation of the device, the depletion region of the first pn junction reaches the floating further region before the first pn junction breaks down, characterised in that the further region forms a further pn junction with a highly doped capping region of the one conductivity type provided within the first device region between the floating further region and the second region and spaced from the second region.

In another aspect, the present invention provides a method of manufacturing a semiconductor device, which method comprises providing a first semiconductor body part having a first region of one conductivity type adjacent one surface, providing a further region of the opposite conductivity type adjacent the one surface within the first body part, providing a second semiconductor body part on the one surface to form with the first body part a semiconductor body having opposed major surfaces and to provide a second region of the one conductivity type on the one surface to form with the first region a first device region within which the further region is floating, and providing adjacent one major surface of the semiconductor body a second device region of the opposite conductivity type forming with the first device region a first pn junction which is spaced from the floating further region so that, when the first pn junction is reverse-biassed in at least one mode of operation of the device, the depletion region of the first pn junction reaches the floating further region before the first pn junction breaks down, characterised by providing adjacent the one surface a highly doped region of the one conductivity type which forms a further pn junction with the further region and provides a capping region between the further region and the second device region spaced from the second device region.

Thus, in a semiconductor device embodying the invention, the floating region is capped by a highly doped region of the one conductivity type which enables a high electric field to exist between the first pn junction and the further floating region without the risk (or with less of a risk) of the pn junction formed by the further floating region with the first device region becoming forward-biassed which enables higher breakdown voltages to be achieved for a given resistivity of the semiconductor body.

Normally, if a single floating further region is provided it should be of comparable extent to the first pn junction, However, an array of floating further regions may be provided with each further region forming a further pn junction with a respective highly doped capping region of the one conductivity type provided within the first device region, the floating further regions being equally spaced from the first pn junction and being spaced from one another by a distance sufficient to avoid merging of the depletion regions associated with the further regions under zero bias. The provision of an array of further regions should allow, in comparison to the use of a single floating further region, a larger area for current flow between the major surfaces of the device which should lessen the possibility of current-crowding problems, especially where the semiconductor device is a vertical device with the main current path extending between the major surfaces. The device may be a bipolar transistor, in which case a third device region of the one conductivity type may be provided within the second device region. In the case of a bipolar transistor, the first device region may form at least part of the collector region of the transistor whilst the second and third device regions form the base and emitter regions, respectively.

In accordance with the other aspect of the invention, the additional region(s) may be provided by introducing impurities of the one conductivity type into the one surface of the first semiconductor body part.

The first semiconductor body part may be provided as an epitaxial layer of the one conductivity type on a monocrystalline substrate and the second semiconductor body part may be provided by, after introducing impurities to form the further regions(s) and the associated capping region(s), growing a further epitaxial layer of the one conductivity type on the first body part. Alternatively, the first and second body parts may be manufactured separately as discrete body parts and then joined together by polishing the surfaces of the first and second body parts to be joined to provide optically-flat, activated surfaces, bringing the polished surfaces into contact to, establish bonding between the first and second body parts and then subjecting the joined body parts to a heat treatment to strengthen the bond. The use of such a bonding technique enables the first and second semiconductor body parts to be formed of monocrystalline semiconductor material which can normally be more lowly doped than epitaxially grown material and so should allow higher breakdown voltages to be achieved. Such methods enable the thickness and dopant concentration within the first and second regions to be chosen to achieve the highest possible breakdown voltage whilst normally maintaining the resistance constant between the major surfaces of the device.

Embodiments of the invention will now be described, by way of example, with reference to the accompanying drawings, in which:
Figures 1 to 3 are cross-sectional views of parts of a semiconductor body for illustrating steps in a first method for manufacturing a semiconductor device in accordance with the invention;
Figure 4a is a view similar to Figure 3 but without any cross-hatching for explaining the operation of the device shown in Figure 3;
Figure 4b is a graph illustrating the change in electrical field E(x) across the device shown in Figure 4a;
Figure 4c illustrates graphically calculated achievable breakdown voltages for different resistivities of the semiconductor body for the device shown in Figure 3 under different conditions; and
Figures 5 and 6 are cross-sectional views of parts of a semiconductor body for illustrating a second method for manufacturing a semiconductor device in accordance with the invention.

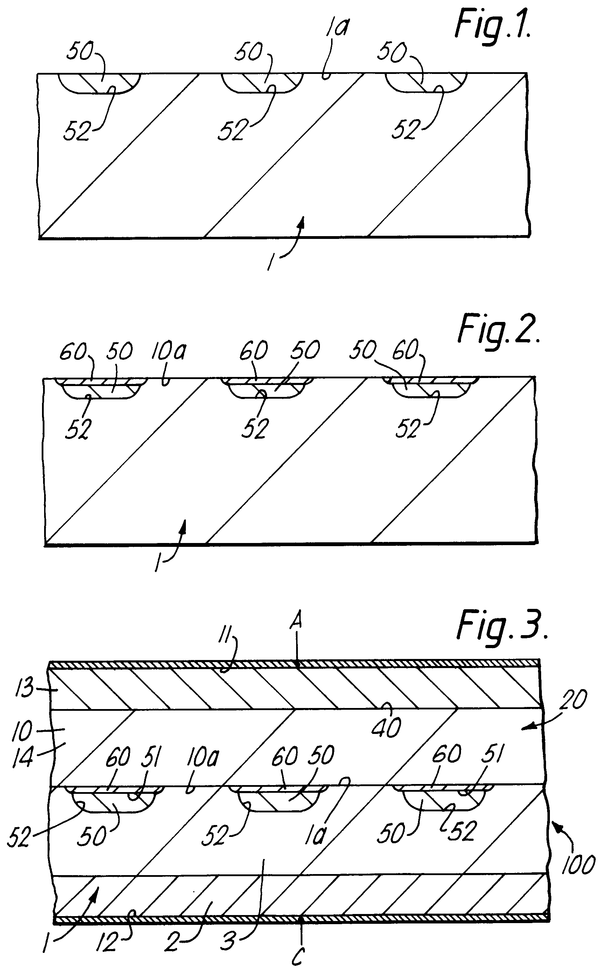

It should be understood that the cross-sectional views of Figures 1 to 3, 4a, 5 and 6 are not to scale and that certain dimensions, especially the thicknesses of layers, may have been exaggerated in the interests of clarity.

Referring now to the drawings, for example Figure 3, there is shown a semiconductor device (in the example shown in Figure 3 a diode) comprising a semiconductor body 100 having a first device region 20 of one conductivity type forming with a second device region 13 of the opposite conductivity type provided adjacent one 11 of the major surfaces 11 and 12 of the semiconductor body 100 a first pn junction 40 which is reverse-biassed in at least one mode of operation of the device, and a floating further region 50 of the opposite conductivity type provided within the first device region 20 remote from the major surfaces 11 and 12 of the semiconductor body 100 and spaced from the second device region 13 so that, in the one mode of operation of the device, the depletion region of the first pn junction 40 reaches the floating further region 50 before the first pn junction 40 breaks down.

In accordance with the invention, the floating further region 50 forms a further pn junction 51 with a highly doped capping region 60 of the one conductivity type provided within the first device region 20 between the floating further region 50 and the second device region 13 and spaced from the second device region 13.

In the examples shown in the drawings, an array of floating further regions 50 is provided with each floating further region forming a further pn junction 51 with a respective highly doped capping region 60. The floating further regions 50 are equally spaced from the first pn junction 40 and are spaced from one another by a distance sufficient to avoid merging of the depletion regions associated with the floating further regions 50 when no bias voltage is applied across the device.

Thus, each floating further region 50 is capped by a highly doped region 60 of the one conductivity type which enables a high electric field to exist between the first pn junction 40 and the further floating region 50 without the risk (or with less of a risk) of the pn junction 52 formed by a further floating region and the first device region 20 becoming forward-biassed so enabling a higher breakdown voltage to be achieved for a given on-resistance or vice versa. The use of an array of floating further regions 50 and associated capping regions 60 should provide a larger area for current flow between the major surfaces 11 and 12 than would be available if a single floating further region 50 of comparable extent to the first pn junction 40 were used.

Figures 1 to 3 illustrate a first method of manufacturing a semiconductor device, in the example shown a diode, in accordance with the invention.

In this example, the semiconductor body 100 is provided as two separate body parts 1 and 10. The first body part 1 is shown in Figure 1 and comprises a first monocrystalline silicon body part which is lowly doped with impurities of the one conductivity type, n conductivity type in this example.

A mask (not shown) is provided on the surface 1a of the first semiconductor body part 1 in conventional manner to enable impurities of the opposite conductivity type, in this example p conductivity type, to be introduced, usually by an ion implantation process although a diffusion process could be used, to form the floating further regions 50.

Although only three floating further regions 50 are shown in the Figures, it will be appreciated that the number of floating further regions 50 may be varied depending on the particular device concerned and the desired reverse breakdown voltage. The spacing of the floating further regions 50 may be adjusted as desired provided that the floating further regions 50 are not placed so close together that the depletion regions associated with the floating further regions 50 merge under zero applied bias and not so far apart that the electric field lines are not influenced by the presence of the floating further regions 50. Typically, the floating further regions 50 may be spaced apart by a distance equal or approximately equal to their width, that is the dimension of the further floating regions 50 measured along the surface 1a. It should also be appreciated that in addition to the spacing, the width, depth and doping concentration of the floating further regions 50 may be adjusted to achieve a desired breakdown voltage.

Again, a conventional mask (not shown) is provided on the surface 1a of the first semiconductor body part 1 and impurities of the one conductivity type, n conductivity type in this example, are introduced, usually by an ion implantation process, although a diffusion process could be used, to form the highly doped capping regions 60. The total charge density of the capping regions 60 should be sufficient to stop the electric field lines and will thus be at least 2 x 10¹² atoms cm⁻². Preferably, the capping regions 60 are formed to be as thin as practically possible bearing in mind the above constraint. In the present example where the semiconductor body is formed of monocrystalline silicon, then the maximum dopant concentration which can be achieved for n conductivity type dopants is about 10²¹ atoms cm⁻³ so that the minimum thickness of the capping region 60 can be about 0.2»m. The mask (not shown) is, of course, designed so that each capping region 60 will form a further pn junction 51 with an associated floating further region 50. The capping regions 60 should be formed to be slightly wider than the associated floating further regions 50 so as to ensure that each floating further region 50 is completely covered by the associated capping region 60, and thus masked from the first pn junction 40, despite possible alignment errors which may arise firstly in the positioning of the mask and mask openings.

Another or second semiconductor body part 10 similarly formed of silicon and being lowly doped with impurities of the one conductivity type is then brought into contact with the first semiconductor body part 1 and the surfaces 1a and 10a of the semiconductor body parts 1 and 10 are then joined together by a technique known as 'slice bonding' or 'slice-wringing'. Thus, the surfaces 1a and 10a are first polished to provide optically flat surfaces activated for bonding, that is surfaces having a surface roughness of less than 50nm and preferably less than 5nm. In this example, this 'mirror-polishing' is achieved by means of a chemomechanical polishing operation in which use is made, for example, of colloidal silicon dioxide in an alkaline solution with an oxidant such as, for example, the polishing agent marketed under the trade name of Syton W 30 by Monsanto.

The two semiconductor body parts 1 and 10 are then brought into contact with one another in a dust-free environment to establish bonding between the surfaces 1a and 10a. It is believed that the bond formed using this technique may be due to van der Waal's bonding or other dipole bonding and may possibly involve bonding of a chemical or quantum mechanical nature between hydroxyl groups at the surfaces 1a and 10a. The joined semiconductor body parts 1 and 10 are then subjected to a heat treatment, typically by heating the joined body parts 1 and 10 to a temperature of about 900 degrees Celsius for about 30 minutes where first and second semiconductor bodies 1 and 10 are formed of silicon, to increase the adhesion between the semiconductor body parts 1 and 10.

After bonding of the semiconductor body parts 1 and 10, impurities of the one conductivity type are introduced into the other major surface 12 of the semiconductor body 100 to form a highly doped layer 2 to enable ohmic contact to the cathode of the diode. Impurities of the opposite conductivity type, p conductivity type in this example, are introduced into the one major surface 11 of the semiconductor body 100 to provide a relatively highly doped layer of the opposite conductivity type which forms the second device or anode region 13 leaving relatively lowly doped portions 3 and 14 of the first and second semiconductor body parts 1 and 10 to form, with the highly doped contact layer 2, the first device or cathode region of the device. If desired, the thickness of the semiconductor body parts 1 and 10 may be reduced by conventional means prior to forming the highly doped layers 2 and 13. Alternatively, each of the semiconductor body parts 1 and 10 may consist of a highly doped substrate 2,13 onto which a lowly doped epitaxial layer 3,14 is grown.

Anode and cathode electrodes A and C for the semiconductor diode may then be provided in conventional manner, for example by depositing aluminium on the surfaces 11 and 12 of the body 100, to complete the diode.

Although in the example described above, the floating further regions 50 and associated capping regions 60 are formed by introducing impurities, via appropriate masks, into the one surface 1a of the first semiconductor body part 1, it is possible for the floating further regions 50 to be formed by introducing impurities into the one surface 1a of the first semiconductor body part 1 and for the associated capping regions 60 to be formed by introducing impurities into the surface 10a of the second semiconductor body part 10 so that the pn junctions 51 between the floating further regions 50 and associated capping regions 60 are not formed until after the first and second semiconductor body parts have been joined together. In this case, however, allowance has to be made for possible additional misalignment errors which may arise during bonding.

It will, of course, be appreciated by those skilled in the art that the structure described above, with any appropriate modification of doping and layer thickness, may be used as a basis for other semiconductor devices such as bipolar transistors, thyristors, etc. If desired, the highly doped layer forming the second device region 13 could be replaced by a planar p conductivity type region or regions, forming, for example, the base region of a bipolar transistor or the body (that is the channel-defining) region of a DMOSFET by introducing impurities through a mask into the first device region 50 in conventional manner. An emitter (or source) region may then be formed within the p conductivity type region in conventional manner.

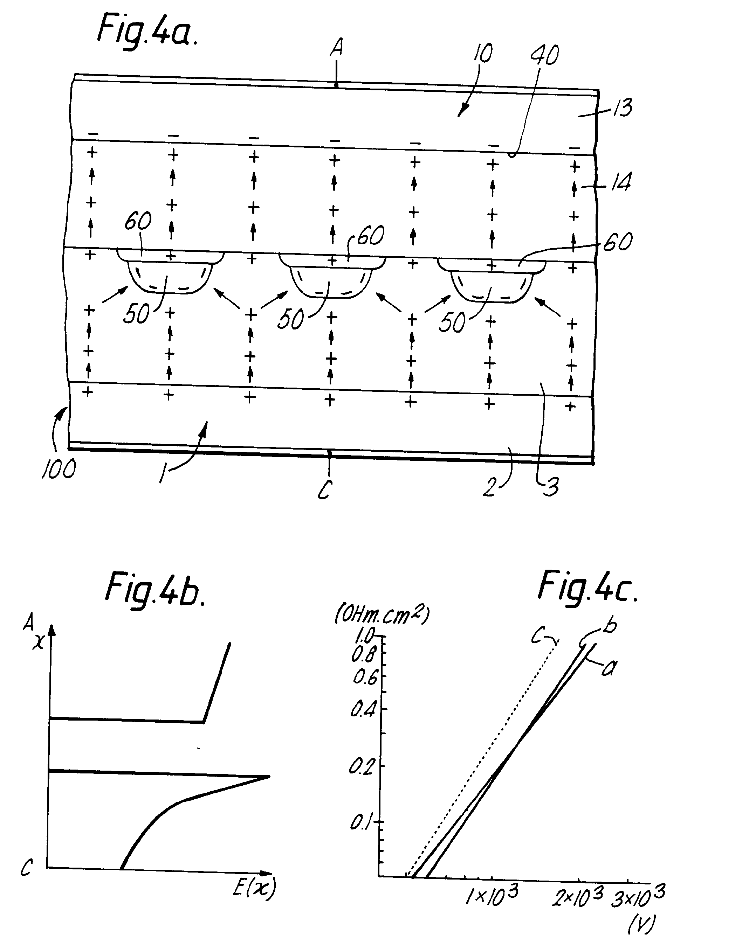

The effect of the provision of the floating further regions 50 and associated capping regions 60 will now be described with reference to Figure 4a which is a cross-sectional view of the semiconductor device similar to Figure 3 but with the cross-hatching omitted and Figure 4b which illustrates graphically the change in the electric field E(x) across the device.

Figure 4a illustrates schematically by means of the arrows ↑ indicating the field lines and the '+' and '-' signs indicating the positive and negative fixed charges, the electric field within the diode when the diode is reverse-biassed and the lowly doped portions 3 and 14 are fully depleted of free charge carriers. As can be clearly seen from Figure 4a, the presence of the negative fixed charges within the floating further regions 50 serves to divert the field lines and so reduce the value of the peak field at the first pn junction 40 where breakdown would otherwise occur. This reduction in the peak field at the first pn junction 40 is at the expense of an increase in the electric field in the immediate vicinity of the floating further regions 50 between the floating further regions 50 and the first pn junction 40. Figure 4b illustrates a typical electric field E(x) distribution with distance x across the device from the cathode C to the anode A through the centre of a floating further region 50. As shown in Figure 46 the electric field E(x) reduces to zero within the floating further region 50. The capping regions 60 allow a high field to exist above the floating further regions so that the field does not serve to forward bias the pn junction 52 between the floating further regions 50 and the first device region 20. The capping regions 60 thus act to increase the reverse-breakdown voltage for a given resistance of the lowly doped portions 3 and 14.

The radius of the further floating regions 50 should not be too small as this would otherwise encourage breakdown at a lower reverse voltage. The effect of junction curvature can be alleviated by reducing the spacing between adjacent floating further regions 50. However, as mentioned above, it is important that this separation of adjacent floating further regions 50 is not so small that, at zero bias, the depletion regions merge because this would throttle or pinch-off current flow between the floating further regions 50 at the beginning of conduction in the ON or forward-biassed state. It is thus, as will be appreciated by those skilled in the art, important to adjust the junction curvature and spacing of the floating further regions 50 appropriately for the particular device concerned.

The thickness and dopant concentration of the lowly doped portions 3 and 14 bounding the floating further regions 50 and associated capping regions 60 may be selected to achieve the highest possible breakdown voltage for a given device structure with the consraint, normally, that the resistance in ohm cm⁻² between the highly doped layers 2 and 13 be maintained constant. Figure 4c illustrates, by means of a graph plotting, both on logarithmic scales, resistance.chip area in ohms cm² against reverse breakdown voltage V in volts, the breakdown voltages which can be achieved for a given resistance under various different conditions for the device described above. Thus in Figure 4c the dotted line c illustrates the situation for a device where the floating further regions 50 (and associated capping regions 60) are not present and so shows the theoretical 'silicon limit' whilst curve a illustrates the situation where the width Wn between the centres of adjacent floating further regions 50 is 20»m, the width Wp of the floating further regions 50 is 15»m and the depth ra at the centre or deepest point of the floating further regions is 7.5»m. In curve b Wn=20»m, ra=10»m and Wp=10»m. As can be seen from Figure 4c, the presence of the further regions 50 and associated capping regions 60 increases the breakdown voltage for a given resistance.chip area.

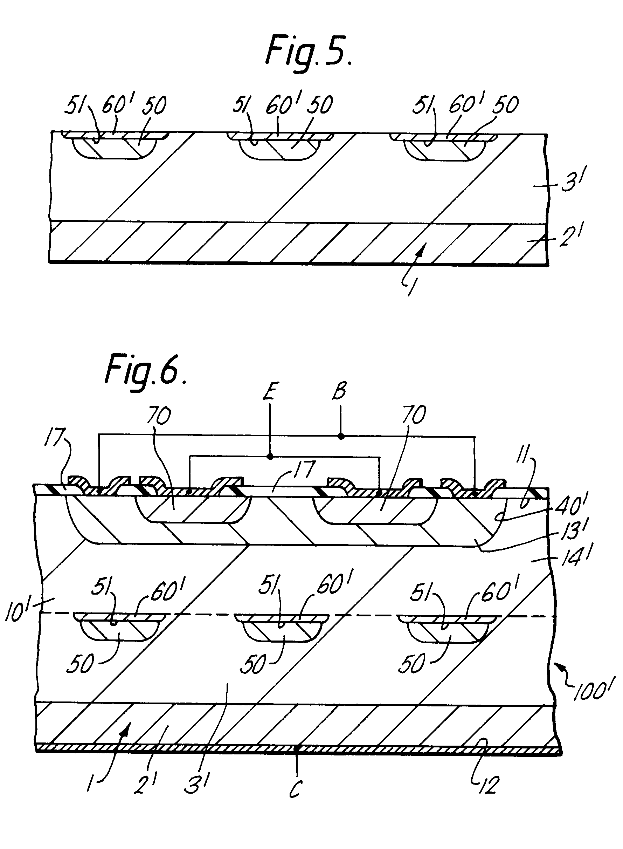

Figures 5 and 6 illustrate a second method for manufacturing a semiconductor device in accordance with the invention.

In this example, the first semiconductor body part 1 is provided as a highly doped monocrystalline substrate 2′ of the one conductivity type onto which is epitaxially grown a lowly doped layer or portion 3′ of the one conductivity type, n conductivity type in this example. After introduction of the impurities to form the floating further regions 50 in a manner similar to that described above, impurities are introduced, using an appropriate conventional mask, to form the capping regions 60′ which will be similar in dimensions and dopant concentration to the capping regions 60 shown in Figure 3.

Then, instead of bringing the first semiconductor body part 1 into contact with a separate second semiconductor body part, the second semiconductor body part is formed by growing a lowly doped epitaxial layer 14′ directly onto the one surface 1a of the first semiconductor body part 1.

The semiconductor body 100′ may again form an epitaxial diode, in which case a further epitaxial layer of the opposite conductivity type is then grown onto the second epitaxial layer 14′ to form the second device region and to complete the semiconductor body 100′. Metallisation may then simply be deposited on the surfaces 11 and 12 of the semiconductor body 100′ to form the anode and cathode contacts. In this example, however, after completion of the second epitaxial layer 14′, p conductivity type impurities are introduced via a mask (not shown) to form a planar base region 13′ of a bipolar transistor, the first device region 20 thus forming the collector region of the transistor. In this case, using an appropriate mask, impurities of the one conductivity type are introduced into the second device region 13′ to form the emitter region 70 of the bipolar transistor. The emitter region 70 may have any desired known emitter pattern, for example, as shown in Figure 6, a plurality of emitter fingers may be provided.

An insulating layer 17, for example a layer of silicon dioxide, is then deposited on the surface 11 of the semiconductor body 100′ and patterned to define contact openings for the emitter and base metallisation. Metallisation is then deposited on the surfaces 11 and 12 in conventional manner to form the emitter, base and collector contacts E, B and C, as shown in Figure 6.

It will be appreciated that the various Figures, being cross-sectional views, do not illustrate the geometry of the devices when viewed in plan, that is when looking towards the surface 11 or 12, and that the floating further regions 50 and associated capping regions 60 may have any desired geometry appropriate for the type and geometry of the device concerned. Thus, the further regions 50 (and associated capping regions 60) may, for example in the case of a semiconductor diode, be provided as, when viewed in plan, annular, circular or rectangular (with rounded corners) regions. Generally, however the floating further regions 50 and associated capping regions 60 will be formed as dots (that is circular cross-section regions) and be arranged in a close-packed array, for example a hexagonal close-packed array.

It should, of course, be understood that the present invention may be applied to other types of semiconductor device, for example vertical MOSFETs, thyristors, diacs, etc. and that it may be used for lateral as well as vertical devices.

The conductivity types given above may be reversed to enable formation of, for example, p channel MOSFETs and pnp bipolar transistors. In addition, the substrate 2 may be of opposite conductivity type to the first epitaxial layer 3 to enable formation of, for example, a thyristor or an insulated gate bipolar transistor. Of course, the present invention may be applied to semiconductor materials other than silicon, for example III-V materials such as gallium arsenide.

From reading the present disclosure, other modifications will be apparent to persons skilled in the art. Such modifications may involve other features which are already known in the semiconductor art and which may be used instead of or in addition to features already described herein. Although claims have been formulated in this application to particular combinations of features, it should be understood that the scope of the disclosure of the present application also includes any novel feature or any novel combination of features disclosed herein either explicitly or implicitly, whether or not it relates to the same invention as presently claimed in any claim and whether or not it mitigates any or all of the same technical problems as does the present invention.

## Claims

1. A semiconductor device comprising a semiconductor body having a first device region of one conductivity type forming with a second device region of the opposite conductivity type provided adjacent one of the major surfaces of the semiconductor body a first pn junction which is reverse-biassed in at least one mode of operation of the device, and a floating further region of the opposite conductivity type provided within the first device region remote from the major surfaces of the semiconductor body and spaced from the second device region so that, in the one mode of operation of the device, the depletion region of the first pn junction reaches the floating further region before the first pn junction breaks down, characterised in that the further region forms a further pn junction with a highly doped capping region of the one conductivity type provided within the first device region between the floating further region and the second device region and spaced from the second device region.

2. A semiconductor device according to Claim 1, further characterised in that an array of floating further regions each forming a further pn junction with a respective highly doped capping region of the one conductivity type is provided within the first device region with the floating further regions being equally spaced from the first pn junction and being spaced from one another by a distance sufficient to avoid merging of the depletion regions associated with the further regions under zero bias.

3. A semiconductor device according to Claim 1 or 2, further characterised in that the first device region extends towards the other major surface of the semiconductor body.

4. A semiconductor device according to Claim 1, 2 or 3, further characterised in that a third device region of the one conductivity type is provided within the second device region.

5. A semiconductor device according to Claim 4, further characterised in that the first device region forms at least part of the collector region of a bipolar transistor with the second and third device regions forming the base and emitter regions, respectively.

6. A method of manufacturing a semiconductor device, which method comprises providing a first semiconductor body part having a first region of one conductivity type adjacent one surface, providing a further region of the opposite conductivity type adjacent the one surface within the first body part, providing a second semiconductor body part on the one surface to form with the first body part a semiconductor body having opposed major surfaces and to provide a second region of the one conductivity type on the one surface to form with the first region a first device region within which the further region is floating, and providing adjacent one major surface of the semiconductor body a second device region of the opposite conductivity type forming with the first device region a first pn junction which is spaced from the floating further region so that, when the first pn junction is reverse-biassed in at least one mode of operation of the device, the depletion region of the first pn junction reaches the floating further region before the first pn junction breaks down, characterised by providing adjacent the one surface a highly doped region of the one conductivity type which forms a further pn junction with the further region and provides a capping region between the further region and the second device region and spaced from the second device region.

7. A method according to Claim 6, further characterised by providing an array of further regions of the opposite conductivity type adjacent the one surface within the first body part and providing a corresponding array of highly doped capping regions of the one conductivity type in the second body part so that each further region forms a further pn junction with a respective capping region, the further region being equally spaced from the first pn junction and being spaced from one another by a distance sufficient to avoid merging of the depletion regions associated with the further regions under zero bias.

8. A method according to Claim 6 or 7, further characterised by providing the first body part so that the first region extends towards the other major surface of the semiconductor body.

9. A method according to Claim 6, 7 or 8, further characterised by providing a third device region of the one conductivity type within the second device region.

10. A method according to any one of claims 6-9, further characterised by providing the capping region(s) by introducing impurities of the one conductivity type into the one surface of the first semiconductor body part.

11. A method according to Claim 6, 7, 8, 9 or 10, further characterised by providing the first semiconductor body part as an epitaxial layer of the one conductivity type on a monocrystalline substrate and by providing the second semiconductor body part by, after introducing impurities to form the further region(s) and the associated capping region(s), growing a further epitaxial layer of the one conductivity type on the first body part.

12. A method according to Claim 6, 7, 8, 9 or 10, further characterised by manufacturing the first and second body parts separately, polishing the surfaces of the first and second body parts to be joined to provide optically-flat, activated surfaces, bringing the polished surfaces into contact to establish bonding between the first and second body parts and subjecting the joined body parts to a heat treatment.

## Patentansprüche

1. Halbleiteranordnung mit einem Halbleiterkörper mit einem ersten Anordnungsbereich mit Leitfähigkeit einer Art, der mit einem zweiten Anordnungsbereich mit Leitfähigkeit der entgegengesetzten Art, der neben einer der Hauptflächen des Halbleiterkörpers bereitgestellt ist, einen ersten pn-Übergang bildet, der in mindestens einer Betriebsart der Anordnung sperr-vorgespannt ist; und mit einem offenen weiteren Bereich mit Leitfähigkeit der entgegengesetzten Art, der innerhalb des ersten Anordnungsbereichs und in entfernter Anordnung von den Hauptflächen des Halbleiterkörpers und beabstandet vom zweiten Anordnungsbereich bereitgestellt ist, so daß bei einer Betriebsart der Anordnung das Verarmungsgebiet des ersten pn-Übergangs den offenen weiteren Bereich erreicht, bevor der erste pn-Übergang durchschlägt, dadurch gekennzeichnet, daß der weitere Bereich einen weiteren pn-Übergang mit einem hoch dotierten Trennbereich mit Leitfähigkeit der ersten Art bildet, der innerhalb des ersten Anordnungsbereichs zwischen dem offenen weiteren Bereich und dem zweiten Anordnungsbereich und vom zweiten Anordnungsbereich beabstandet bereitgestellt ist.

2. Halbleiteranordnung nach Anspruch 1, weiter dadurch gekennzeichnet, daß eine Matrix aus offenen weiteren Bereichen, von denen jeder einen weiteren pn-Übergang mit einem entsprechenden hoch dotierten Trennbereich mit Leitfähigkeit der einen Art bildet, innerhalb des ersten Anordnungsbereichs bereitgestellt ist, wobei die offenen weiteren Bereiche vom ersten pn-Übergang gleich beabstandet sind und wobei sie untereinander mit einer Distanz beabstandet sind, die ausreichend ist, um die Vermischung der Verarmungsgebiete in Zusammenhang mit den weiteren Bereichen unter Vorpannung null zu vermeiden.

3. Halbleiteranordnung nach Anspruch 1 oder 2, weiter dadurch gekennzeichnet, daß sich der erste Anordnungsbereich in Richtung auf die andere Hauptfläche des Halbleiterkörpers erstreckt.

4. Halbleiteranordnung nach Anspruch 1, 2 oder 3, weiter dadurch gekennzeichnet, daß innerhalb des zweiten Anordnungsbereichs ein dritter Anordnungsbereich mit Leitfähigkeit der einen Art bereitgestellt ist.

5. Halbleiteranordnung nach Anspruch 4, weiter dadurch gekennzeichnet, daß der erste Anordnungsbereich mindestens einen Teil der Kollektorzone eines bipolaren Transistors bildet, wobei der zweite und der dritte Anordnungsbereich die Basis- beziehungsweise die Emitterzone bilden.

6. Verfahren zur Herstellung einer Halbleiteranordnung, wobei das Verfahren die Bereitstellung eines ersten Halbleiterkörperteils mit einem ersten Bereich mit Leitfähigkeit einer ersten Art neben einer ersten Fläche umfaßt, sowie die Bereitstellung eines weiteren Bereichs mit Leitfähigkeit der entgegengesetzten Art neben der betreffenden Fläche innerhalb des ersten Körperteils und die Bereitstellung eines zweiten Halbleiterkörperteils auf der betreffenden Fläche, um mit dem ersten Körperteil einen Halbleiterkörper zu bilden, der sich gegenüberliegende Hauptflächen hat, und um einen zweiten Bereich mit Leitfähigkeit der ersten Art auf der betreffenden Fläche bereitzustellen, um mit dem ersten Bereich einen ersten Anordnungsbereich zu bilden, in dem der weitere Bereich offen ist, und die Bereitstellung eines zweiten Anordnungsbereichs mit Leitfähigkeit der entgegengesetzten Art neben einer Hauptfläche des Halbleiterkörpers, der mit dem ersten Anordnungsbereich einen ersten pn-Übergang bildet, der vom offenen weiteren Bereich beabstandet ist, so daß, wenn der erste pn-Übergang in mindestens einer Betriebsart der Anordnung sperr-vorgespannt ist, das Verarmungsgebiet des ersten pn-Übergangs den offenen weiteren Bereich erreicht, bevor der erste pn-Übergang durchschlägt, dadurch gekennzeichnet, daß neben der einen Fläche ein hoch dotierter Bereich mit Leitfähigkeit der ersten Art bereitgestellt wird, der einen weiteren pn-Übergang mit dem weiteren Bereich bildet und der zwischen dem weiteren Bereich und dem zweiten Anordnungsbereich und beabstandet vom zweiten Anordnungsbereich einen Trennbereich bereitstellt.

7. Verfahren nach Anspruch 6, weiter dadurch gekennzeichnet, daß neben der betreffenden Fläche innerhalb des ersten Körperteils eine Matrix aus weiteren Bereichen mit Leitfähigkeit der entgegengesetzten Art bereitgestellt wird und daß eine entsprechende Matrix hoch dotierter Trennbereiche mit Leitfähigkeit der ersten Art im zweiten Körperteil bereitgestellt wird, so daß jeder weitere Bereich mit einem entsprechenden Trennbereich einen weiteren pn-Übergang bildet, wobei die weiteren Bereiche vom ersten pn-Übergang gleich beabstandet sind und wobei sie untereinander mit einer Distanz beabstandet sind, die ausreichend ist, um die Vermischung der Verarmungsgebiete in Zusammenhang mit den weiteren Bereichen unter Vorspannung null zu vermeiden.

8. Verfahren nach Anspruch 6 oder 7, weiter dadurch gekennzeichnet, daß das erste Körperteil so bereitgestellt wird, daß sich der erste Bereich in Richtung auf die andere Hauptfläche des Halbleiterkörpers erstreckt.

9. Verfahren nach Anspruch 6, 7 oder 8, weiter dadurch gekennzeichnet, daß innerhalb des zweiten Anordnungsbereichs ein dritter Anordnungsbereich mit Leitfähigkeit der einen Art bereitgestellt ist.

10. Verfahren nach einem der Ansprüche 6-9, weiter dadurch gekennzeichnet, daß der (die) Trennbereich(e) bereitgestellt wird (werden), indem in die betreffende Fläche des ersten Halbleiterkörperteils Störstellen mit Leitfähigkeit der ersten Art eingeführt werden.

11. Verfahren nach Anspruch 6, 7, 8, 9 oder 10, weiter dadurch gekennzeichnet, daß das erste Halbleiterkörperteil als Epitaxialschicht mit Leitfähigkeit der ersten Art auf einem monokristallinen Substrat bereitgestellt wird und daß das zweite Halbleiterkörperteil bereitgestellt wird, indem nach der Einführung von Störstellen zur Bildung des (der) weiteren Bereichs (Bereiche) und des (der) dazugehörigen Trennbereichs (Trennbereiche) eine weitere Epitaxialschicht mit Leitfähigkeit der ersten Art auf dem ersten Körperteil aufgewachsen wird.

12. Verfahren nach Anspruch 6, 7, 8, 9 oder 10, weiter dadurch gekennzeichnet, daß die ersten und zweiten Körperteile getrennt hergestellt werden, wobei die Oberflächen der ersten und zweiten zusammenzufügenden Körperteile poliert werden, um optisch glatte, aktivierte Oberflächen bereitzustellen, und wobei die polierten Oberflächen in Kontakt gebracht werden, um ein Bonden zwischen den ersten und zweiten Körperteilen herzustellen, und wobei anschließend die zusammengefügten Körperteile einer Wärmebehandlung unterzogen werden.

## Revendications

1. Dispositif semiconducteur comportant un corps semiconducteur présentant une première région de dispositif d'un premier type de conductivité formant avec une seconde région de dispositif du type de conductivité opposé prévue à proximité d'une première des surfaces principales du corps semiconducteur une première jonction pn qui, dans au moins un mode de fonctionnement du dispositif, est polarisée en inverse, et une autre région flottante de type de conductivité opposé prévue dans la première région de dispositif, à distance des surfaces principales du corps semiconducteur et de façon à être séparée de la seconde région de dispositif de sorte que, dans le premier mode de fonctionnement du dispositif, la région de déplétion de la première jonction pn atteint l'autre région flottante avant le claquage de la première jonction pn, caractérisé en ce que l'autre région forme une autre jonction pn avec une région de recouvrement fortement dopée du premier type de conductivité prévue dans la première région de dispositif, entre l'autre région flottante et la seconde région, tout en étant séparée de la seconde région.

2. Dispositif semiconducteur selon la revendication 1, encore caractérisé en ce que, dans la première région de dispositif, est prévue un réseau d'autres régions flottantes formant chacune une autre jonction pn avec une région de recouvrement fortement dopée correspondante du premier type de conductivité, les autres régions flottantes étant situées à la même distance de la première jonction pn et étant séparées les unes des autres par un écartement suffisant pour éviter la fusion des régions de déplétion associées aux autres régions à une tension de polarisation nulle.

3. Dispositif semiconducteur selon la revendication 1 ou 2, encore caractérisé en ce que la première région de dispositif s'étend vers l'autre surface principale du corps semiconducteur.

4. Dispositif semiconducteur selon la revendication 1, 2 ou 3, encore caractérisé en ce que, dans la seconde région de dispositif, est prévue une troisième région de dispositif du premier type de conductivité.

5. Dispositif semiconducteur selon la revendication 4, encore caractérisé en ce que la première région de dispositif fait au moins partie de la région de collecteur d'un transistor bipolaire, les deuxième et troisième régions de dispositif formant respectivement les régions de base et d'émetteur.

6. Procédé de fabrication d'un dispositif semiconducteur, comportant les étapes consistant à prévoir une première partie de corps semiconducteur présentant une première région d'un premier type de conductivité située à proximité une première des surfaces, à prévoir une autre région du second type de conductivité située à proximité de la première surface, au sein de la première partie de corps, à prévoir une seconde partie de corps semiconducteur sur la première surface de façon qu'elle forme avec la première partie de corps un corps semiconducteur ayant des surfaces principales opposées et qu'elle fournisse une seconde région du premier type de conductivité sur la première surface de façon à former avec la première région une première région de dispositif dans laquelle l'autre région est flottante, et à prévoir à proximité de la première surface du corps semiconducteur une seconde région de dispositif de type de conductivité opposé formant avec la première région de dispositif une première jonction pn qui est séparée de l'autre région flottante, de sorte que, lorsque la première jonction pn est polarisée en sens inverse dans au moins un mode de fonctionnement du dispositif, la région de déplétion de la première jonction pn atteint l'autre région flottante avant le claquage de la première jonction pn, caractérisé en ce qu'on forme à proximité de la première surface une région fortement dopée du premier type de conductivité qui, avec l'autre région, forme une autre jonction pn et qui fournit une région de recouvrement entre la première région et la seconde région de dispositif, séparée de la seconde région de dispositif.

7. Procédé selon la revendication 6, encore caractérisé en ce que, dans la première partie de corps, on forme un réseau d'autres régions de type de conductivité opposé à proximité de la première surface et, dans la seconde partie de corps, on forme un réseau correspondant de régions de recouvrement correspondantes fortement dopées du premier type de conductivité, de sorte que chaque autre région forme avec une région de recouvrement correspondante une autre jonction pn, les autres régions étant situées à la même distance de la première jonction pn et étant séparées les unes des autres par un écartement suffisant pour éviter la fusion des régions de déplétion associées aux autres régions à une tension de polarisation nulle.

8. Procédé selon la revendication 6 ou 7, encore caractérisé en ce qu'on forme la première partie de corps de façon que la première région s'étende vers l'autre surface principale du cors semiconducteur.

9. Procédé selon la revendication 6, 7 ou 8, encore caractérisé en ce qu'on forme une troisième région de dispositif du premier type de conductivité dans la seconde région de dispositif.

10. Procédé selon l'une quelconque des revendications 6 à 9, encore caractérisé en ce qu'on forme la (les) région(s) de recouvrement en introduisant des impuretés du premier type de conductivité dans la première surface de la première partie de corps semiconducteur.

11. Procédé selon la revendication 6, 7, 8, 9 ou 10, encore caractérisé en ce qu'on réalise la première partie de corps semiconducteur sous la forme d'une couche épitaxiale du premier type de conductivité sur un substrat monocristallin et en ce qu'on forme la seconde partie de corps semiconducteur en procédant, après l'introduction d'impuretés pour former la (les) autre(s) région(s) et la (les) région(s) de recouvrement associée(s), à la croissance d'une autre couche épitaxiale du premier type de conductivité sur la première partie de corps.

12. Procédé selon la revendication 6, 7, 8, 9 ou 10, encore caractérisé en ce qu'on réalise séparément les premier et seconde parties de corps, en ce qu'on polit les surfaces à réunir des première et seconde parties de corps de façon à fournir des surfaces activées optiquement plates, en ce qu'on met en contact les surfaces polies pour établir la liaison entre les première et seconde parties de corps et en ce qu'on soumet les parties de corps réunies à un traitement thermique.
